# EUROPEAN PATENT APPLICATION

(11) **EP 4 580 373 A1**
(43) Date of publication of application: **02.07.2025**
(21) Application number: 24209665.9
(22) Date of filing: 30.10.2024
(51) Int. Cl.: H10K 59/131

(54) **TRANSPARENT DISPLAY APPARATUS**

(30) Priority: 29.12.2023 KR 20230197355
(71) Applicant: LG Display Co., Ltd., Seoul 07336 (KR)
(72) Inventor: YOHN, Gyujae, 10845 Paju-si (KR)
(74) Representative: Morrall, Jonathan Ian McLachlan

(57) **Abstract**

Disclosed is a transparent display apparatus comprising a substrate including a transmission area and a non-transmission area having an emission area in which a light emitting element is disposed, at least one gate line crossing the non-transmission area and the transmission area on the substrate, and a gate bridge pattern in the transmission area of the substrate and at least partially overlapped with the at least one gate line. The transparent display apparatus of the present disclosure has the high light transmittance and improves the reflectance characteristics.

## Description

### CROSS-REFERENCE TO RELATED APPLICATION

This application claims priority to Korean Patent Application No. 10-2023-0197355 filed in the Republic of Korea on December 29, 2023.

### TECHNICAL FIELD

The present disclosure relates to a transparent display apparatus.

### BACKGROUND

With the development of information society, the demand for a display apparatus for displaying an image is increasing in various forms. Accordingly, display apparatuses such as a liquid crystal display (LCD) apparatus, an organic light emitting display (OLED) apparatus, a micro light emitting diode (LED) display apparatus, a quantum dot display (QD) apparatus, and the like are used.

Recently, research on a transparent display apparatus has been actively conducted, which not only displays an image to a user, but also transmits light therethrough so that a user can see an object or image located behind the display apparatus. The transparent display apparatus includes a display area in which an image is displayed and a non-display area, wherein the display area may include a transmission area capable of transmitting external light and a non-transmission area. The transparent display apparatus may have a high light transmittance in the display area through the transmission area.

According as images and background can be viewed together, the transparent display apparatus is highly likely to be used in various fields. However, since there are various fields and uses to which transparent display apparatus is applied, the transparent display apparatus needs to be manufactured in various types (or various sizes). However, when the transparent display apparatus is manufactured with various types (or various sizes), a manufacturing cost and production energy increase due to the increase in the number of processes.

### SUMMARY

An aspect of the present disclosure is directed to providing a transparent display apparatus which has a high light transmittance and improves the reflectance characteristics.

Another aspect of the present disclosure is directed to providing a transparent display apparatus capable of being manufactured in various types (or various sizes).

The objects of the present disclosure are not limited to the aforesaid, but other objects not described herein will be clearly understood by those skilled in the art from descriptions below.

A transparent display apparatus according to an embodiment of the present disclosure may include a substrate including a transmission area and a non-transmission area having an emission area in which a light emitting element is disposed, at least one gate line crossing the non-transmission area and the transmission area on the substrate, and a gate bridge pattern disposed in the transmission area of the substrate and at least partially overlapped with the at least one gate line.

A transparent display apparatus according to another embodiment of the present disclosure may include a substrate including a transmission area and a non-transmission area having an emission area in which a light emitting element is disposed; at least one undercut line disposed in the transmission area on the substrate and extending in a first direction; at least one gate line crossing the non-transmission area and the transmission area on the substrate, the at least one gate line including a divided portion spaced apart by a predetermined interval at a portion crossing the at least one undercut line in the transmission area; and a connection bridge pattern disposed at a portion where the at least one gate line and the at least one undercut line, the divided portion of the at least one gate line being electrically connected by the connection bridge pattern.

According to the embodiment of the present disclosure, it is possible to provide the transparent display apparatus which has the high light transmittance and improves the reflectance characteristics.

According to the embodiment of the present disclosure, it is possible to provide the transparent display apparatus capable of being manufactured in various types (or various sizes).

The effects of the present disclosure are not limited to the aforesaid, but other effects not described herein will be clearly understood by those skilled in the art from descriptions below.

The details of the present disclosure described in technical problem, technical solution, and advantageous effects do not specify essential features of claims, and thus, the scope of claims is not limited by the details described in detailed description of the invention.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain principles of the disclosure.
FIG. 1 illustrates a transparent display apparatus according to an embodiment of the present disclosure.
FIG. 2 is a circuit diagram of a subpixel of a transparent display apparatus according to an embodiment of the present disclosure.
FIG. 3 illustrates a region A shown in FIG. 1 according to an embodiment of the present disclosure.
FIG. 4 illustrates a region B shown in FIG. 3 according to one embodiment of the present disclosure.
FIG. 5 illustrates a region C shown in FIG. 4 according to one embodiment of the present disclosure.
FIG. 6 is a cross-sectional view along I-I' of FIG. 5 according to one embodiment of the present disclosure.
FIG. 7 illustrates a region B shown in FIG. 3 according to another embodiment of the present disclosure.
FIG. 8 illustrates a region D shown in FIG. 7 according to another embodiment of the present disclosure.
FIG. 9 is a cross-sectional view along II-II' of FIG. 8 according to another embodiment of the present disclosure.
FIG. 10 illustrates a region B shown in FIG. 3 according to another embodiment of the present disclosure.
FIG. 11 illustrates a region E shown in FIG. 10 according to another embodiment of the present disclosure.
FIG. 12 is a cross-sectional view along III-III' of FIG. 11 according to another embodiment of the present disclosure.
FIG. 13 illustrates a region B shown in FIG. 3 according to another embodiment of the present disclosure.
FIG. 14 illustrates a region F shown in FIG. 13 according to another embodiment of the present disclosure.
FIG. 15 is a cross-sectional view along IV-IV' of FIG. 14 according to another embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and/or convenience.

### DETAILED DESCRIPTION

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete, to assist those skilled in the art to understand the inventive concepts without limiting the protected scope of the present disclosure.

Shapes (e.g., sizes, lengths, widths, heights, thicknesses, locations, radii, diameters, and areas), sizes, ratios, angles, numbers, and the like disclosed herein, including those illustrated in the drawings are merely examples, and thus, the present disclosure is not limited to the illustrated details. Any implementation described herein as an "example" is not necessarily to be construed as preferred or advantageous over other implementations. It is, however, noted that the relative dimensions of the components illustrated in the drawings are part of the present disclosure.

When the term "comprise," "have," "include," "contain," "constitute," "made of," "formed of," or the like is used with respect to one or more elements, one or more other elements may be added unless a term such as "only" or the like is used. The terms used in the present disclosure are merely used in order to describe example embodiments, and are not intended to limit the scope of the present disclosure. The terms of a singular form may include plural forms unless the context clearly indicates otherwise.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element is "connected," "coupled," "attached," "adhered," or the like to another element, the element may not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element is "contacts," "overlaps," or the like with another element, the element may not only directly contact, overlap, or the like with another element, but also indirectly contact, overlap, or the like with another element with one or more intervening elements disposed or interposed between the elements, unless otherwise specified.

The term "at least one" should be understood as including any and all combinations of one or more of the associated listed items. For example, "at least one among a first element, a second element and a third element" may include all combinations of two or more elements selected from the first, second and third elements as well as each element of the first, second and third elements.

Features of various embodiments of the present disclosure may be partially or entirety coupled to or combined with each other, may be technically associated with each other, and may be variously inter-operated, linked or driven together. The embodiments of the present disclosure may be implemented or carried out independently of each other, or may be implemented or carried out together in a co-dependent or related relationship. In one or more aspects, the components of each apparatus according to various embodiments of the present disclosure are operatively coupled and configured.

In the following description, various example embodiments of the present disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

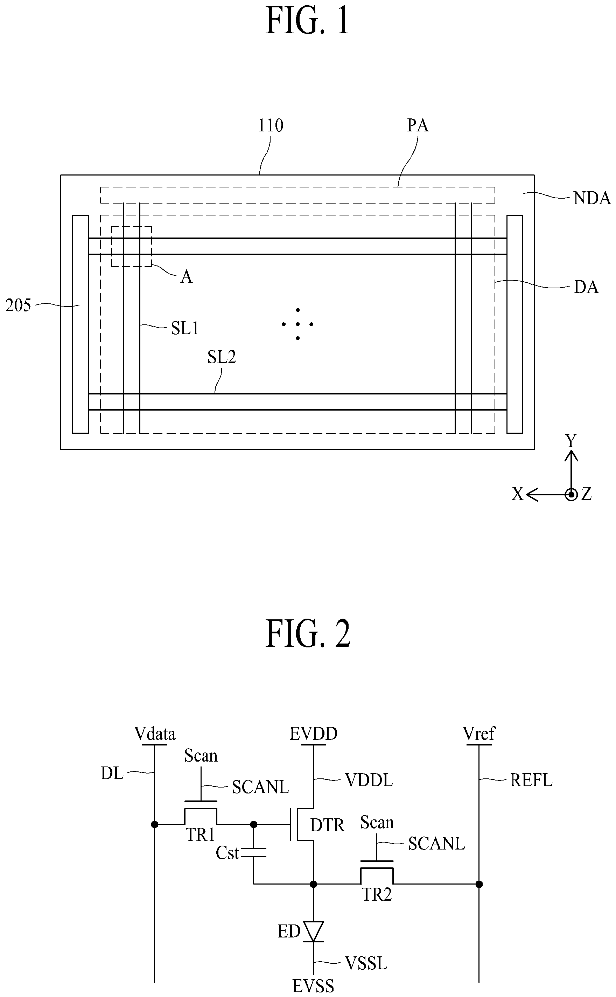

FIG. 1 illustrates a transparent display apparatus according to an embodiment of the present disclosure. FIG. 2 is a circuit diagram of a subpixel of the transparent display apparatus according to the embodiment of the present disclosure.

Hereinafter, an X-axis represents a direction parallel to a scan line, a Y-axis represents a direction parallel to a data line, and a Z-axis represents a thickness direction of the transparent display apparatus.

The transparent display apparatus according to one embodiment of the present disclosure is implemented as an organic light emitting display (OLED). However, it may be implemented as a liquid crystal display (LCD)device, a micro light emitting diode (Micro LED) Display, a quantum dot (QD) Display, or the like.

Referring to FIGs. 1 and 2, the transparent display apparatus according to one embodiment of the present disclosure may include a transparent display panel 110 having a display area DA and a non-display area NDA, wherein the display area DA is provided with pixels to display an image and an image is not displayed on the non-display area NDA.

The display area DA of the transparent display panel 110 may include first signal lines SL1, second signal lines SL2, and pixels, and the non-display area NDA may include a pad area PA in which pads are disposed and at least one gate driver 205.

The first signal lines SL1 may extend in a first direction (or Y-axis direction), and may intersect the second signal lines SL2 in the display area DA. The second signal lines SL2 may extend in a second direction (or X-axis direction). The pixels are disposed in a region where the first signal line SL1 and the second signal line SL2 cross each other, and may emit a predetermined light to display an image.

The gate driver 205 may be connected to a scan line to supply a scan signal. The gate driver 205 may be implemented in a gate driver in panel (GIP) type or a tape automated bonding (TAB) type in the non-display area NDA on one side or both sides of the display area DA of the transparent display panel 110.

A source drive integrated circuit, a circuit board, or a timing controller connected through a flexible circuit film may be electrically connected to the pad area PA of the transparent display panel 110.

Referring to FIG. 2, each of the pixels includes a plurality of subpixels constituting a unit pixel. In each of the plurality of subpixels, there are a circuit element having 3T(Transistor)1C(Capacitor) structure including a first switching transistor TR1, a second switching transistor TR2, a driving transistor DTR and a capacitor Cst, and a light emitting element ED, but not limited thereto. Each subpixel may further include a compensation circuit. In this case, the subpixel may have various structures such as 4T2C, 5T2C, 6T1C, 6T2C, 7T1C, and 7T2C.

Each of the transistors DTR, TR1, and TR2 of each subpixel may include a gate electrode, a source electrode, and a drain electrode. According as the source electrode and the drain electrode may be changed according to a voltage applied to the gate electrode and a current direction without being fixed, any one of the source electrode and the drain electrode may be represented as a first electrode, and the other may be represented as a second electrode. The transistors DTR, TR1, and TR2 of each subpixel may use at least one of polysilicon semiconductor, amorphous silicon semiconductor, and oxide semiconductor. The transistors DTR, TR1, and TR2 may be P-type or N-type, or P-type and N-type may be interchangeably used.

The first switching transistor TR1 may serve to supply a data voltage Vdata supplied from the data line DL to the driving transistor DTR. For example, the first switching transistor TR1 may charge the data voltage Vdata supplied from the data line DL to the capacitor Cst. To this end, the gate electrode of the first switching transistor TR1 is connected to the scan line SCANL (or gate line), and the first electrode thereof is connected to the data line DL. In addition, the second electrode of the first switching transistor TR1 may be connected to one end of the capacitor Cst and the gate electrode of the driving transistor DTR.

The first switching transistor TR1 may be turned-on in response to the scan signal Scan applied through the scan line SCANL (or gate line). When the first switching transistor TR1 is turned-on, the data voltage Vdata applied through the data line DL may be transferred to one end of the capacitor Cst.

The second switching transistor TR2 may serve to supply a reference voltage Vref supplied from a reference line REFL to the driving transistor DTR. For example, the gate electrode of the second switching transistor TR2 is connected to the scan line SCANL (or gate line), and the first electrode thereof is connected to the reference line REFL. In addition, the second electrode of the second switching transistor TR2 may be connected to the first electrode of the driving transistor DTR and the other end of the capacitor Cst.

The second switching transistor TR2 may be turned-on in response to the scan signal Scan applied through the scan line (or gate line). When the second switching transistor TR2 is turned-on, the reference voltage Vref applied through the reference line REFL may be transferred to the other end of the capacitor Cst. In addition, the reference voltage Vref may also be applied to the source electrode of the driving transistor DTR.

The capacitor Cst maintains the data voltage Vdata supplied to the driving transistor DTR for one frame. For example, the first electrode of the capacitor Cst may be connected to the gate electrode of the driving transistor DTR, and the second electrode of the capacitor Cst may be connected to the source electrode of the driving transistor DTR. The capacitor Cst may store a voltage corresponding to the data voltage Vdata transferred through the first switching transistor TR1, and may turn on the driving transistor DTR with the stored voltage.

The driving transistor DTR may generate a data current from a first power EVDD supplied from a pixel power line VDDL and may supply the data current to an anode electrode of the light emitting element ED. For example, the gate electrode of the driving transistor DTR may be connected to one end of the capacitor Cst, and the first electrode of the driving transistor DTR may be connected to the pixel power line VDDL. In addition, the second electrode of the driving transistor DTR may be connected to the anode electrode of the light emitting element ED.

The driving transistor DTR may be turned-on according to the data voltage charged in the capacitor Cst. When the driving transistor DTR is turned-on, the first power EVDD applied through the pixel power line VDDL may be transmitted to the anode electrode of the light emitting element ED.

The light emitting element ED may include an anode electrode connected to the driving transistor DTR, a cathode electrode suppled with a second power EVSS from a common power line VSSL, and a light emitting layer between the anode electrode and the cathode electrode. The anode electrode is an independent electrode for each light emitting element, however, the cathode electrode may be a common electrode shared by the entire light emitting elements. When a driving current is supplied from the driving transistor DTR, electrons from the cathode electrode are injected into the light emitting layer, and holes from the anode electrode are injected into the light emitting layer, whereby fluorescent or phosphorescent materials emit by a recombination of the electrons and holes in the light emitting layer, thereby generating light of brightness proportional to a current value of the driving current.

The anode electrode of the light emitting element ED is connected to the second electrode of the driving transistor DTR, and the cathode electrode of the light emitting element ED is connected to the common power line VSSL. The light emitting element ED may emit light in response to the driving current generated by the driving transistor DTR.

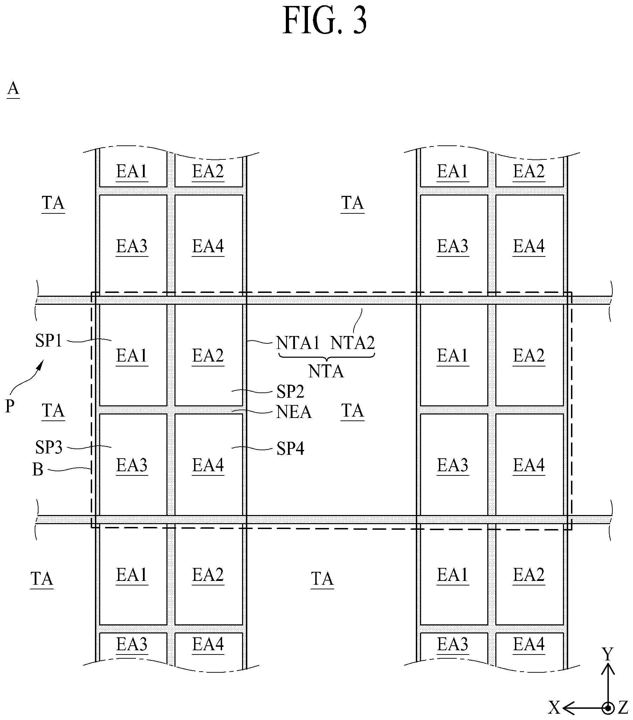

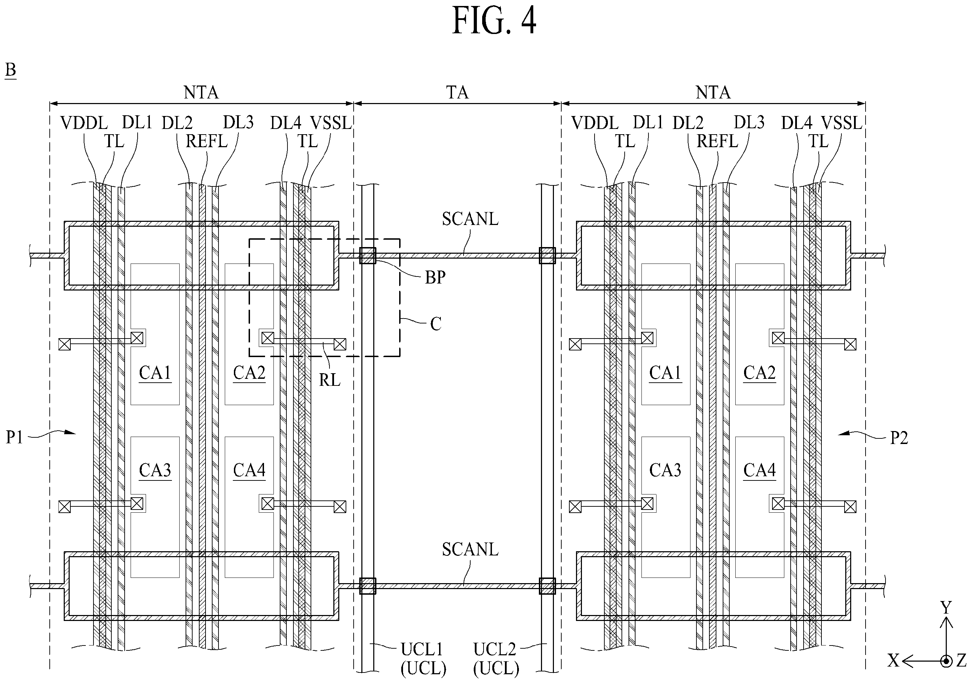

FIG. 3 illustrates a region A shown in FIG. 1 according to an embodiment of the present disclosure. FIG. 4 illustrates a region B shown in FIG. 3 according to one embodiment of the present disclosure.

Referring to FIGs. 3 and 4 in connection with FIGs. 1 and 2, a transparent display panel 110 according to an embodiment of the present disclosure may include a display area DA and a non-display area NDA. The display area DA may include a transmission area TA and a non-transmission area NTA. The transmission area TA may be an area through which most of light incident from the outside passes, and the non-transmission area NTA may be an area which does not transmit most of light incident from the outside. For example, the transmission area TA may be an area in which a light transmittance is greater than α%, and the non-transmission area NTA may be an area in which a light transmittance is less than β%. Herein, 'α' may be a value greater than '0'. The transparent display panel 110 enables a user to see an object or background located behind the transparent display panel 110 owing to the transmission areas TA.

The non-transmission area NTA may include a first non-transmission area NTA1, a second non-transmission area NTA2, and pixels P.

The first non-transmission area NTA1 may extend in the first direction (or Y-axis direction) on the display area DA, and may be disposed to at least partially overlap emission areas EA1, EA2, EA3, and EA4. There may be the plurality of first non-transmission area NTA1. The plurality of first non-transmission areas NTA1 may extend in the first direction (or Y-axis direction) and may be spaced apart from each other in the second direction (or X-axis direction). The two adjacent first non-transmission areas NTA1 may be arranged to be spaced apart from each other with the transmission area TA interposed therebetween. For example, the transmission area TA may be arranged between the two adjacent first non-transmission areas NTA1. The first signal lines SL1 extending in the first direction (or Y-axis direction) may be disposed in the first non-transmission area NTA1. For example, the first signal lines SL1 may be disposed to overlap the first non-transmission area NTA1.

The first signal lines SL1 may include at least one of the pixel power line VDDL, the common power line VSSL, the reference line REFL, and the data lines DL1, DL2, DL3, and DL4. For example, the first signal lines SL1 may further include a touch sensor line TL, but embodiments of the present disclosure are not limited thereto.

The pixel power line VDDL may supply a first power EVDD to the driving transistor DTR of each of the subpixels SP1, SP2, S 3, and SP4 provided in the display area DA.

The common power line VSSL may supply the second power EVSS to the cathode electrode of the subpixels SP1, SP2, SP3, and SP4 provided in the display area DA. In this case, the second power EVSS may be a common power commonly supplied to the subpixels SP1, SP2, SP3, and SP4.

The reference line REFL may supply an initialization voltage (or reference voltage) to the driving transistor DTR of each of the subpixels SP1, SP2, SP3, and SP4 provided in the display area DA. For example, the reference line REFL may be disposed between the plurality of data lines DL1, DL2, DL3, and DL4. For example, the reference line REFL may be disposed in the middle of the plurality of data lines DL1, DL2, DL3, and DL4.

Each of the data lines DL1, DL2, DL3, and DL4 may supply the data voltage Vdata to the subpixels SP1, SP2, SP3, and SP4. For example, the first data line DL1 supplies the first data voltage to the first driving transistor of the first subpixel SP1, the second data line DL2 supplies the second data voltage to the second driving transistor of the second subpixel SP2, the third data line DL3 supplies the third data voltage to the third driving transistor of the third subpixel SP3, and the fourth data line DL4 supplies the fourth data voltage to the fourth driving transistor of the fourth subpixel SP4.

At least two touch sensor lines TL may be arranged in the first non-transmission area NTA1. When the plurality of touch sensor lines TL are disposed in the transmission area TA of the transparent display panel 110, a light transmittance may be degraded due to the plurality of touch sensor lines TL. For this reason, the touch sensor line TL may be disposed in the first non-transmission area NTA1 rather than the transmission area TA. For example, the touch sensor line TL may be disposed to overlap at least one of the pixel power line VDDL and the common power line VSSL in the first non-transmission area NTA1. For example, the touch sensor line TL may be disposed on a different layer from the pixel power line VDDL and the common power line VSSL. The touch sensor line TL is not overlapped with a circuit area CA1, CA2, CA3, and CA4 in which a circuit element is disposed, and is disposed to overlap with at least one of the pixel power line VDDL and the common power line VSSL or disposed adjacent to at least one of the pixel power line VDDL and the common power line VSSL. For example, the plurality of touch sensor lines may be disposed in the first non-transmission area NTA1. For example, when the four touch sensor lines are disposed, the two touch sensor lines may overlap or may be adjacent to the pixel power line VDDL, and the other two touch sensor lines may overlap or may be adjacent to the common power line VSSL, but embodiments of the present disclosure are not limited thereto.

The second non-transmission area NTA2 may extend in the second direction (or X-axis direction) on the display area DA, and may be disposed to at least partially overlap the emission areas EA1, EA2, EA3, and EA4. For example, the second non-transmission area NTA2 may extend in the second direction (or X-axis direction) between the two adjacent first non-transmission areas NTA1. There may be the plurality of second non-transmission areas NTA2. The plurality of second non-transmission areas NTA2 may extend in the second direction (or X-side direction) and may be spaced apart from each other in the first direction (or Y-axis direction). The two adjacent second non-transmission areas NTA2 may be arranged to be spaced apart from each other with the transmission area TA interposed therebetween. For example, the transmission area TA may be arranged between the two adjacent second non-transmission areas NTA2. The second signal lines SL2 extending in the second direction (or X-axis direction) may be disposed in the second non-transmission area NTA2. For example, the second signal lines SL2 may be disposed to overlap the second non-transmission area NTA2.

The second signal lines SL2 extend in the second direction (or X-axis direction) and include the scan line SCANL (or gate line). The scan line SCANL may supply the scan signal to the subpixels SP1, SP2, SP3, and SP4 of the pixel P.

The pixels P may be arranged in each crossing area where the first non-transmission area NTA1 and the second non-transmission area NTA2 cross each other, and may emit light to display an image. Each of the pixels P is disposed between the adjacent transmission areas TA, and the pixel P may include the emission areas EA1, EA2, EA3, and EA4 in which the light emitting element is disposed to emit light. The emission area EA1, EA2, EA3, and EA4 may correspond to an area in which light is emitted from the pixel P. Since the area of the non-transmission area NTA is small, the circuit element may be disposed to overlap the emission areas EA1, EA2, EA3, and EA4 in the transparent display panel 110. For example, the emission areas EA1, EA2, EA3, and EA4 may at least partially overlap the circuit areas CA1, CA2, CA3, and CA4 in which the circuit elements are disposed. For example, the circuit area CA1 , CA2, CA3, and CA4 may include the first circuit area CA1 in which the circuit element connected to the first subpixel SP1 is disposed, the second circuit area CA2 in which the circuit element connected to the second subpixel SP2 is disposed, the third circuit area CA3 in which the circuit element connected to the third subpixel SP3 is disposed, and the fourth circuit area CA4 in which the circuit element connected to the fourth subpixel SP4 is disposed.

All the first to fourth emission areas EA1, EA2, EA3, and EA4 may respectively emit light of different colors. For example, the first emission area EA1 may emit green light, the second emission area EA2 may emit red light, the third emission area EA3 may emit blue light, and the fourth emission area EA4 may emit white light, but not limited thereto. In addition, the arrangement order or arrangement form of each of the subpixels SP1, SP2, SP3, and SP4 may be variously changed.

The transparent display panel 110 according to an embodiment of the present disclosure may include light emitting areas in which the plurality of emission areas EA1, EA2, EA 3, and EA4 respectively included in the plurality of subpixels SP1, SP2, SP3, and SP4 are divided. For example, each of the first to fourth emission areas EA1, EA2, EA3, and EA4 may include a first divided light emitting area and a second divided light emitting area which are divided into two, but not limited thereto.

The pixel circuits CA1, CA2, CA3, and CA4 in each of the plurality of subpixels SP1, SP2, SP3, and SP4 may include a capacitor Cst, at least one thin film transistor DTR, TR1, and TR2, and a light emitting element ED, as shown in FIG. 2. For example, at least one thin film transistor DTR, TR1, and TR2 may include a driving transistor DTR, a first switching transistor TR1, and a second switching transistor TR2. In addition, the light emitting element ED may include a first electrode (or anode electrode, pixel electrode), a light emitting layer (or organic light emitting layer), and a second electrode (or cathode electrode, common electrode).

The transparent display panel 110 according to an embodiment of the present disclosure may further include at least one undercut line UCL extending in the first direction (or Y-axis direction) in the transmission area TA.

The at least one undercut line UCL may disconnect the light emitting layer (or organic light emitting layer) formed in the transmission area TA. The at least one undercut line UCL may be configured as a part of at least one protection layer (for example, planarization layer and passivation layer). For example, at least one undercut line UCL may be formed by removing at least a portion of at least one protection layer (for example, planarization layer and passivation layer). The scan line SCANL (or gate line) crossing the transmission area TA may be disposed under at least one undercut line UCL. A block pattern BP may be further included in a portion at which the at least one undercut line UCL and the scan line SCANL intersect. For example, the block pattern BP may prevent damage on the scan line SCANL crossing the lower portion of at least one undercut line UCL in a process of forming at least one undercut line UCL.

The at least two undercut lines UCL may be disposed in the transmission area TA. The at least one undercut line UCL may be disposed adjacent to at least one of the pixel power line VDDL and the common power line VSSL in the transmission area TA. For example, the at least one undercut line UCL may be disposed adjacent to each of the pixel power line VDDL and the common power line VSSL in the transmission area TA. For example, the at least one undercut line UCL may be composed of the plurality of undercut lines UCL1 and UCL2 in one transmission area TA. The plurality of undercut lines UCL1 and UCL2 may include the first undercut line UCL1 and the second undercut line UCL2. For example, the first undercut line UCL1 may be disposed adjacent to the pixel P1 on one side of the transmission area TA, and the second undercut line UCL2 may be disposed adjacent to the pixel P2 on the other side of the transmission area TA.

The first undercut line UCL1 may disconnect the light emitting layer (or the organic light emitting layer) extending from the pixel P1 on one side of the transmission area TA, and the second undercut line UCL2 may disconnect the light emitting layer (or organic light emitting layer) extending from the pixel P2 on the other side of the transmission area TA. The area between the first undercut line UCL1 and the second undercut line UCL2 may be the area disconnected from the light emitting layer (or organic light emitting layer) of each pixel P1 and P2 on one side and the other side of the transmission area TA. For example, the first undercut line UCL1 and the second undercut line UCL2 may be formed by removing at least a portion of at least one protection layer (for example, planarization layer and passivation layer). For example, the at least one protection layer may include an organic insulating layer, and the first undercut line UCL1 and the second undercut line UCL2 may be formed by removing at least a portion of the organic insulating layer, thereby disconnecting the organic insulating layer. Accordingly, moisture permeation may be prevented or at least reduced in the area between the pixel P1 on one side of the transmission area TA and the transmission area TA by the first undercut line UCL1, and moisture permeation may be prevented in the area between the pixel P2 on the other side of the transmission area TA and the transmission area TA by the second undercut line UCL2. Accordingly, even when the area between the first undercut line UCL1 and the second undercut line UCL2 is cut by a cutting device such as laser or wheel, moisture permeation may be prevented in the pixels P1 and P2 on one side and the other side of the transmission area TA.

The transparent display panel 110 according to an embodiment of the present disclosure is configured to extend the first undercut line UCL1 and the second undercut line UCL2 in the first direction (or Y-axis direction) inside the transmission area TA, so that it is possible to prevent or at least reduced moisture permeation into the adjacent pixel P1 by the first undercut line UCL1 and to prevent or at least reduced moisture permeation into the adjacent pixel P2 by the second undercut line UCL2. Accordingly, even though the space between the first undercut line UCL1 and the second undercut line UCL2 is cut (or separated), it may be the cutting-enable area capable of preventing moisture from permeating into the pixel P1 and P2. Therefore, the transparent display panel 110 according to an embodiment of the present disclosure provides the cutting-enable area in the transmission area TA by the undercut line UCL, whereby it is possible to implement or realize a cuttable transparent display panel which can be manufactured by being divided into various sizes according to the application and use of the transparent display panel 110.

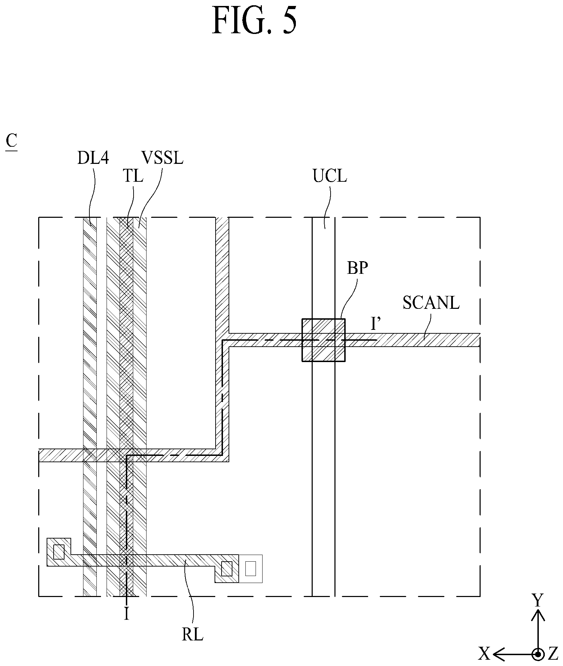

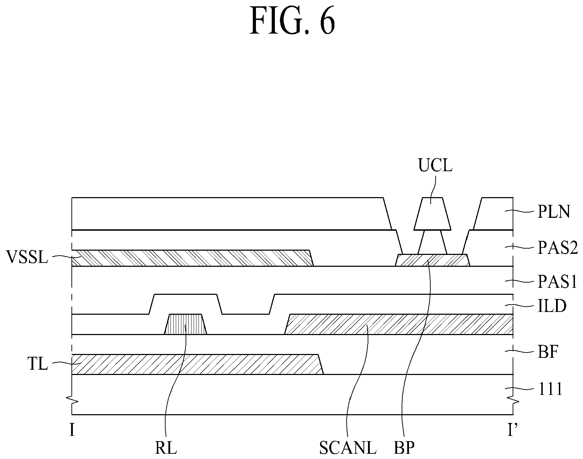

FIG. 5 illustrates a region C shown in FIG. 4 according to one embodiment of the present disclosure. FIG. 6 is a cross-sectional view along I-I' of FIG. 5 according to one embodiment of the present disclosure.

Referring to FIGs. 5 and 6, a transparent display panel 110 according to an embodiment of the present disclosure may include at least one first signal line (for example, data line DL, touch sensor line TL, common power line VSSL) disposed in the non-transmission area NTA and extending in the first direction (or Y-axis direction), and at least one second signal line (for example, scan line SCANL) crossing the transmission area TA and extending in the second direction (or X-axis direction). The transparent display panel 110 according to an embodiment of the present disclosure may further include at least one undercut line UCL disposed in the transmission area TA and extending in the first direction (or Y-axis direction).

Specifically, the touch sensor line TL of the first signal line may be disposed on a substrate 111. The touch sensor line TL may be arranged to extend in the first direction (or Y-axis direction) in the non-transmission area NTA. For example, the touch sensor line TL may be disposed to overlap at least one of the pixel power line VDDL and the common power line VSSL. For example, the touch sensor line TL may be disposed on a different layer from the pixel power line VDDL and the common power line VSSL. For example, the touch sensor line TL may be disposed to overlap the common power line VSSL.

The touch sensor line TL may be disposed at the lowermost end of the substrate 111. The touch sensor line TL may be formed of the same material on the same layer as a light shielding layer disposed on the substrate 111. For example, the light shielding layer may serve to block external light incident to an active layer of the thin film transistor. The light shielding layer may be formed in a single-layered structure or multi-layered structure of molybdenum (Mo), aluminum (Al), chromium (Cr), gold (Au), titanium (Ti), nickel (Ni), neodymium (Nd), and copper (Cu), or an alloy thereof. For example, the first signal line formed of the same material on the same layer as the light shielding layer on the substrate 111 may be formed with at least one of the touch sensor line TL, the pixel power line VDDL, the common power line VSSL, the reference line REFL, and the data line DL, but embodiments of the present disclosure are not limited thereto.

A buffer layer BF may be disposed on the substrate 111 on which the touch sensor line TL and the light shielding layer are disposed. The buffer layer BF protects the thin film transistor vulnerable to moisture permeation from moisture penetrating through the substrate 111. The buffer layer BF may be formed in a single-layered structure or a multi-layered structure including an inorganic insulating material such as silicon oxide (SiOx), silicon nitride (SiNx), aluminum oxide (Al₂O₃), and the like.

The scan line SCANL, which is the second signal line, may be disposed on the buffer layer BF. The scan line SCANL may be arranged in the non-transmission area NTA and the transmission area TA. For example, at least a portion of the scan line SCANL may be arranged to extend in the second direction (or X-axis direction) to cross the transmission area TA. At least a portion of the scan line SCANL may be disposed to intersect with at least one of the pixel power line VDDL, the common power line VSSL, and the touch sensor line TL. For example, the scan line SCANL may be disposed on a different layer from the pixel power line VDDL, the common power line VSSL, and the touch sensor line TL. The scan line SCANL may include a portion bent at least once and extending in the first direction (or Y-axis direction).

The scan line SCANL may be formed of the same material on the same layer as the gate electrode of the thin film transistor disposed on the buffer layer BF. For example, a thin film transistor may be disposed on the buffer layer BF. The thin film transistor may include an active layer, a gate insulating layer, a gate electrode, and a source/drain electrode disposed on the buffer layer BF. The gate insulating layer may be disposed between the active layer and the gate electrode. For example, the gate insulating layer may be formed in the area where the gate electrode is disposed. An interlayer insulating layer ILD may be disposed between the gate electrode and the source/drain electrode of the thin film transistor.

A repair line RL for repairing a dark spot of the light emitting element may be disposed on the same layer as the scan line SCANL. For example, the first electrode (or anode electrode) of the light emitting element may be divided into two of first and second divided electrodes, and the repair line RL may electrically connect the first and second divided electrodes to the pixel circuit. For example, the repair line RL may be disposed to intersect with the touch sensor line TL disposed on the substrate 111. The repair line RL may be formed of a different material on a different layer from the touch sensor line TL. For example, the touch sensor line TL may be formed of the same material as the light shielding layer, and the repair line RL and the touch sensor line TL may be spaced apart from each other with the buffer layer BF interposed therebetween.

An interlayer insulating layer ILD may be disposed on the substrate 111 on which the scan line SCANL and the repair line RL are disposed. The interlayer insulating layer ILD may be formed in a single-layered structure or a multi-layered structure including an inorganic insulating material such as silicon oxide (SiOx), silicon nitride (SiNx), aluminum oxide (Al₂O₃), and the like.

A source/drain electrode of the thin film transistor may be disposed on the interlayer insulating layer ILD. At least some of the touch sensor line TL, the pixel power line VDDL, the common power line VSSL, the reference line REFL, and the data line DL may be formed on the same layer as the source/drain electrode. For example, the source/drain electrode may be formed of the same material on the same layer as the data line DL, but embodiments of the present disclosure are not limited thereto.

A first passivation layer PAS1 may be disposed on the interlayer insulating layer ILD on which the source/drain electrode and the data line DL are disposed. A second passivation layer PAS2 may be disposed on the first passivation layer PAS 1. The first passivation layer PAS 1 and the second passivation layer PAS2 may be formed as a single layer or multiple layers including an inorganic insulating material such as silicon oxide (SiOx), silicon nitride (SiNx), aluminum oxide (Al₂O₃), and the like.

The pixel power line VDDL and the common power line VSSL may be disposed on the first passivation layer PAS 1. For example, the pixel power line VDDL and the common power line VSSL may be disposed between the first passivation layer PAS1 and the second passivation layer PAS2. The pixel power line VDDL and the common power line VSSL may be disposed to overlap the touch sensor line TL on the substrate 111.

A planarization layer PLN for planarizing a step difference by the thin film transistor and the plurality of signal lines may be disposed on the second passivation layer PAS2. The planarization layer PLN may be formed of an organic material such as acryl resin, epoxy resin, phenolic resin, polyamide resin, polyimide resin, or the like.

The transparent display panel 110 according to an embodiment of the present disclosure may provide an undercut line UCL by using the planarization layer PLN and the second passivation layer PAS2. For example, the undercut line UCL may extend in the first direction (or Y-axis direction) in the transmission area TA. The undercut line UCL may be formed by removing at least a portion of the planarization layer PLN and the second passivation layer PAS2. For example, the undercut line UCL may be formed in a pillar structure having a line-shaped eaves structure extending along the first direction (or Y-axis direction), which is formed by removing a portion of the planarization layer PLN, and a line-shaped structure for supporting the planarization layer PLN, which is formed by removing a portion of the second passivation layer PAS2 more inward than the planarization layer PLN. For example, the undercut line UCL may be formed in the structure composed of the pillar structure including the second passivation layer PAS2 and the eaves structure of the planarization layer PLN on the upper surface of the second passivation layer PAS2.

The scan line SCANL (or gate line) crossing the transmission area TA may be disposed under the undercut line UCL. The block pattern BP may be disposed at an intersection of the undercut line UCL and the scan line SCANL. For example, the block pattern BP may be formed at a portion where the undercut line UCL and the scan line SCANL intersect.

The block pattern BP prevents or at least reduces the scan line SCANL from being damaged from an etchant used when the undercut line UCL is formed. For example, the block pattern BP may be formed between the undercut line UCL and the scan line SCANL. The block pattern BP may be formed on the first passivation layer PAS 1. For example, the block pattern BP may be formed of the same material as another signal line formed on the first passivation layer PAS 1. For example, the block pattern BP may be formed of the same material on the same layer as the pixel power line VDDL and the common power line VSSL.

The transparent display panel 110 according to an embodiment of the present disclosure may provide the cutting-enable area in the transmission area TA by the undercut line UCL so that it is possible to implement or realize a cuttable transparent display panel manufactured by being divided into various sizes according to the application and use. However, in the transparent display panel 110 according to an embodiment of the present disclosure, the light transmittance or reflectance properties may be degraded due to at least one scan line SCANL crossing the transmission area TA and the block pattern BP disposed in the transmission area TA. Accordingly, the inventors of the present disclosure invent a transparent display apparatus having a new structure capable of improving the light transmittance and reflectance properties of a transparent display panel 110 through various studies and experiments.

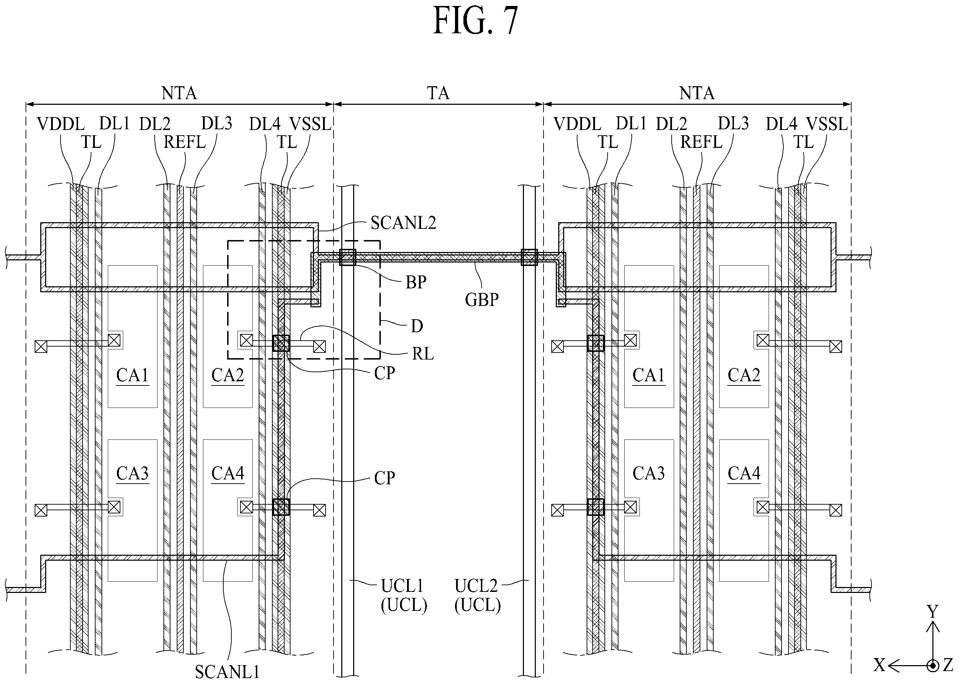

Hereinafter, a transparent display apparatus according to another embodiment of the present disclosure having improved light transmittance and improved reflectance characteristics of a transparent display panel 110 will be described in more detail with reference to FIGs. 7 to 15.

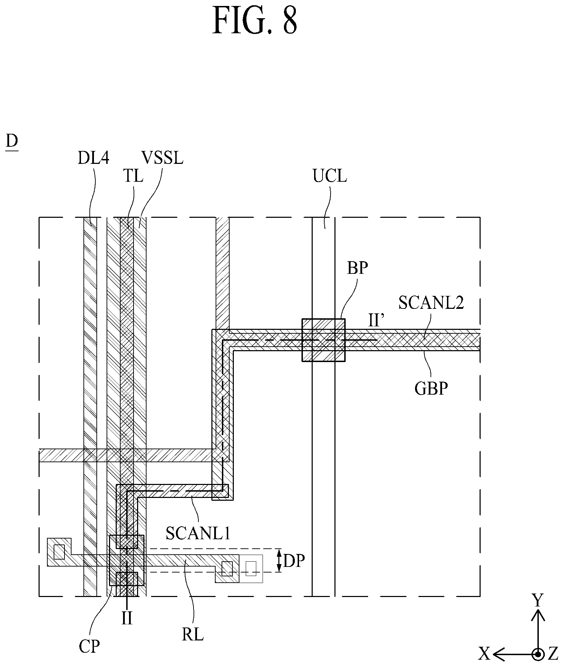

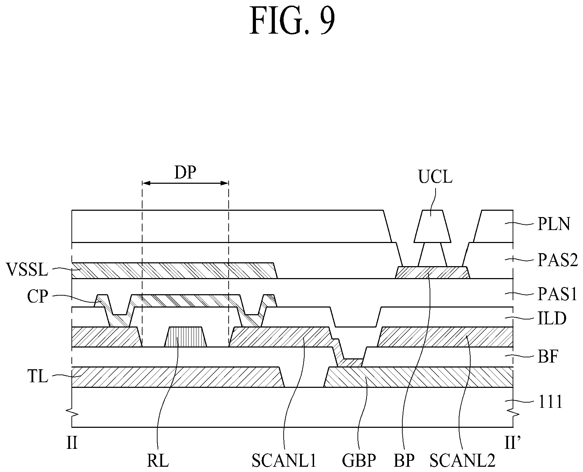

FIG. 7 illustrates a region B shown in FIG. 3 according to another embodiment of the present disclosure. FIG. 8 illustrates a region D shown in FIG. 7 according to another embodiment of the present disclosure. FIG. 9 is a cross-sectional view along II-II' of FIG. 8 according to another embodiment of the present disclosure. FIGs. 7 to 9 are configured by changing a scan line from the transparent display panel 110 described with reference to FIGs. 1 to 6. Accordingly, in the following description, the same reference numerals are assigned to the same elements except for a configuration related to the scan line , and a redundant description thereof will be omitted or briefly described.

Referring to FIGs. 7 to 9, the transparent display panel 110 according to another embodiment of the present disclosure may include at least one scan line SCANL and a gate bridge pattern GBP.

At least one scan line SCANL may include a first scan line SCANL1 and a second scan line SCANL2. For example, the first scan line SCANL1 and the second scan line SCANL2 may be connected to respective pixels P corresponding to adjacent horizontal lines. For example, the horizontal line may mean a line in which the plurality of pixels P are arranged in parallel along a second direction (or X-axis direction). For example, the first scan line SCANL1 may be connected to the pixels P corresponding to the lower horizontal line of the two adjacent horizontal lines. For example, the lower horizontal line may be the horizontal line corresponding to the pixels P lower-positioned with respect to the pixel P shown in FIG. 7. The second scan line SCANL2 may be connected to the pixels P corresponding to the upper horizontal line of the two adjacent horizontal lines. For example, the upper horizontal line may be the horizontal line corresponding to the pixel P shown in FIG. 7, but embodiments of the present disclosure are not limited thereto. For example, the first scan line SCANL1 and the second scan line SCANL2 may provide different scan signals to the pixels P corresponding to one horizontal line. For example, the first scan line SCANL1 and the second scan line SCANL2 may provide the different scan signals to the pixels P corresponding to the horizontal line corresponding to the pixel P shown in FIG. 7.

The first scan line SCANL1 may be disposed in a non-transmission area NTA. For example, at least a portion of the first scan line SCANL1 may extend in the second direction (or X-axis direction) in the non-transmission area NTA. The first scan line SCANL 1 may be bent at least once in the non-transmission area NTA and may extend in a first direction (or Y-axis direction). For example, the first scan line SCANL1 may be disposed to overlap at least one of a touch sensor line TL, a pixel power line VDDL, and a common power line VSSL in the non-transmission area NTA. The first scan line SCANL1 may be disposed on a different layer from the touch sensor line TL, the pixel power line VDDL, and the common power line VSSL. The first scan line SCANL1 may include a divided portion DP spaced apart from each other in the non-transmission area NTA. For example, the divided portion DP of the first scan line SCANL1 may be formed at a portion of the first scan line SCANL1 crossing a repair line RL so as to repair a dark spot of a light emitting element. The divided portion DP of the first scan line SCANL1 may be electrically connected by a connection pattern CP.

The second scan line SCANL2 may be disposed in the non-transmission area NTA and transmission area TA. For example, at least a portion of the second scan line SCANL2 may be disposed to extend in the second direction (or X-axis direction) to cross the transmission area TA. At least a portion of the second scan line SCANL2 may be disposed to cross at least one of the pixel power line VDDL, the common power line VSSL, and the touch sensor line TL. For example, the second scan line SCANL2 may be disposed on a different layer from the pixel power line VDDL, the common power line VSSL, and the touch sensor line TL. The second scan line SCANL2 may include a portion bent at least once and extending in the first direction (or Y-axis direction). The second scan line SCANL2 may be formed of the same material on the same layer as the first scan line SCANL1. The second scan line SCANL2 and the first scan line SCANL1 may be spaced apart from each other while being provided on the same layer, and may be electrically separated from each other.

The gate bridge pattern GBP may be disposed in the transmission area TA. The gate bridge pattern GBP may partially overlap with at least one scan line SCANL. In addition, the gate bridge pattern GBP may be electrically connected to at least one scan line SCANL. For example, the gate bridge pattern GBP may partially overlap the first scan line SCANL1 and the second scan line SCANL2. The gate bridge pattern GBP may be electrically connected to the first scan line SCANL1 and may be electrically separated from the second scan line SCANL2. For example, the gate bridge pattern GBP may be disposed on a different layer from the first scan line SCANL1 and the second scan line SCANL2. The gate bridge pattern GBP overlaps an end portion of the first scan line SCANL1 and the gate bridge pattern GBP may be electrically connected to the end portion of the first scan line SCANL1 through a contact hole passing through an insulating layer between the first scan line SCANL1 and the gate bridge pattern GBP. The gate bridge pattern GBP may extend in parallel to the second scan line SCANL2. The gate bridge pattern GBP is not in direct contact with the second scan line SCANL2, and the gate bridge pattern GBP may be spaced apart from the second scan line SCANL2 with at least one insulating layer interposed therebetween. The gate bridge pattern GBP may extend in the second direction (or X-axis direction) to overlap the second scan line SCANL2 in the transmission area TA.

Specifically, the touch sensor line TL and the gate bridge pattern GBP may be arranged on a substrate 111. The touch sensor line TL may be arranged to extend in the first direction (or Y-axis direction) in the non-transmission area NTA. For example, the touch sensor line TL may be disposed to overlap at least one of the pixel power line VDDL and the common power line VSSL. The gate bridge pattern GBP may extend in the first direction (or Y-axis direction) in the non-transmission area NTA and may be bent in the second direction (or X-axis direction) to extend across the transmission area TA. For example, the touch sensor line TL and the gate bridge pattern GBP may be formed of the same material on the same layer. The touch sensor line TL and the gate bridge pattern GBP may be disposed on a layer different from the first scan line SCANL1, the second scan line SCANL2, the pixel power line VDDL, and the common power line VSSL. For example, the touch sensor line TL may be disposed to overlap the common power line VSSL. The gate bridge pattern GBP may be disposed to partially overlap the first scan line SCANL1 and the second scan line SCANL2.

The touch sensor line TL and the gate bridge pattern GBP may be disposed at the lowermost end of the substrate 111. The touch sensor line TL and the gate bridge pattern GBP may be formed of the same material on the same layer as a light shielding layer disposed on the substrate 111. For example, the light shielding layer may serve to block external light incident to an active layer of a thin film transistor. The light shielding layer may be formed in a single-layered structure or multi-layered structure of molybdenum (Mo), aluminum (Al), chromium (Cr), gold (Au), titanium (Ti), nickel (Ni), neodymium (Nd), and copper (Cu), or an alloy thereof.

A buffer layer BF may be disposed on the substrate 111 on which the touch sensor line TL, the gate bridge pattern GBP, and the light shielding layer are disposed. The buffer layer BF protects the thin film transistor vulnerable to moisture permeation from moisture penetrating through the substrate 111. The buffer layer BF may be formed in a single-layered structure or a multi-layered structure including an inorganic insulating material such as silicon oxide (SiOx), silicon nitride (SiNx), aluminum oxide (Al₂O₃), and the like.

The first scan line SCANL1 and the second scan line SCANL2 may be disposed on the buffer layer BF. The first scan line SCANL1 may be disposed in the non-transmission area NTA, and the second scan line SCANL2 may be disposed in the non-transmission area NTA and the transmission area TA.

The first scan line SCANL1 may extend in the second direction (or X-axis direction) in the non-transmission area NTA and may be bent and extend in the first direction (or Y-axis direction). For example, the first scan line SCANL1 may be connected to the pixels P corresponding to the lower horizontal line of the two adjacent horizontal lines. For example, the first scan line SCANL1 may be connected to the pixels P corresponding to the lower horizontal line of the two adjacent horizontal lines, may extend in the second direction (or X-axis direction), and may be bent in the first direction (or Y-axis direction) to extend to partially overlap the touch sensor line TL. For example, a portion of the first scan line SCANL1 may extend to overlap the touch sensor line TL in the first direction (or Y-axis direction). For example, the first scan line SCANL1 may be disposed to overlap at least a portion of the touch sensor line TL, the pixel power line VDDL, and the common power line VSSL extending in the first direction (or Y-axis direction).

The repair line RL for repairing the dark spot of the light emitting element may be disposed on the same layer as the first scan line SCANL1. For example, a first electrode (or anode electrode) of the light emitting element may be divided into two, that is, first and second divided electrodes, and the repair line RL may electrically connect the first and second divided electrodes to a pixel circuit. The first scan line SCANL1 may include the divided portion DP spaced a predetermined distance apart in a portion extending in the first direction (or Y-axis direction). The divided portion DP of the first scan line SCANL1 may be formed at a portion of the first scan line SCANL1 crossing the repair line RL disposed on the same layer. The first scan line SCANL1 is spaced apart from the repair line RL by the divided portion DP, and may be electrically separated from the repair line RL.

An end portion of the first scan line SCANL1 may overlap the gate bridge pattern GBP on the substrate 111. The end portion of the first scan line SCANL1 may be electrically connected to the gate bridge pattern GBP through a contact hole that penetrates the buffer layer BF and exposes the gate bridge pattern GBP. The gate bridge pattern GBP electrically connected to the first scan line SCANL1 may serve to transmit the same signal as the first scan line SCANL1.

The second scan line SCANL2 may be disposed in the non-transmission area NTA and the transmission area TA. At least a portion of the second scan line SCANL2 may be disposed to extend in the second direction (or X-axis direction) to cross the transmission area TA. At least a portion of the second scan line SCANL2 may be disposed to cross at least one of the pixel power line VDDL, the common power line VSSL, and the touch sensor line TL. For example, the second scan line SCAN 2 may be disposed on a different layer from the pixel power line VDDL, the common power line VSSL, and the touch sensor line TL. The scan line SCANL may include a portion bent at least once and extending in the first direction (or Y-axis direction).

The portion of the second scan line SCANL2 extending in the second direction (or X-axis direction) to cross the transmission area TA may overlap the gate bridge pattern GBP. At least a portion of the second scan line SCANL2 may overlap the gate bridge pattern GBP and extend in parallel to the gate bridge pattern GBP. The second scan line SCANL2 may be spaced apart from the gate bridge pattern GBP, which serves as the first scan line SCANL1, with the buffer layer BF interposed therebetween, and may be electrically separated from the gate bridge pattern GBP. The second scan line SCANL2 and the gate bridge pattern GBP may share an area crossing the transmission area TA and so that it is possible to additionally secure a margin of the transmission area TA, thereby improving light transmittance of the transparent display panel 110.

The first scan line SCANL1, the second scan line SCAN 2, and the repair line RL may be formed of the same material on the same layer as a gate electrode of the thin film transistor disposed on the buffer layer BF. For example, the thin film transistor may be disposed on the buffer layer BF. The thin film transistor may include the active layer, a gate insulating layer, the gate electrode, and a source/drain electrode disposed on the buffer layer BF. The gate insulating layer may be disposed between the active layer and the gate electrode. For example, the gate insulating layer may be formed only in an area where the gate electrode is disposed. An interlayer insulating layer ILD may be disposed between the gate electrode and the source/drain electrode of the thin film transistor.

The interlayer insulating layer ILD may be disposed on the substrate 111 on which the first scan line SCANL1, the second scan line SCANL2, and the repair line RL are disposed. The interlayer insulating layer ILD may be formed in a single-layered structure or a multi-layered structure including an inorganic insulating material such as silicon oxide (SiOx), silicon nitride (SiNx), aluminum oxide (Al₂O₃), and the like.

The connection pattern CP may be disposed on the interlayer insulating layer ILD and may be configured to electrically connect the divided portion DP of the first scan line SCANL1. The connection pattern CP may be formed of the same material on the same layer as the source/drain electrode of the thin film transistor disposed on the interlayer insulating layer ILD. For example, the connection pattern CP and the source/drain electrode may be formed of the same material on the same layer as a data line DL, but embodiments of the present disclosure are not limited thereto.

The connection pattern CP may overlap at least a portion of the first scan line SCANL1 and the repair line RL which passes through the divided portion DP of the first scan line SCANL1. One end and the other end of the connection pattern CP may be respectively connected to one end and the other end of the first scan line SCANL1 spaced apart from each other with the divided portion DP interposed therebetween via a contact hole exposing a portion of the first scan line SCANL1 by penetrating through the interlayer insulating layer ILD. One end and the other end of the first scan line SCANL1 spaced apart from each other by the divided portion DP may be electrically connected to each other by the connection pattern CP.

A first passivation layer PAS1 may be disposed on the interlayer insulating layer ILD on which the connection pattern CP, the source/drain electrode, and the data line DL are disposed. A second passivation layer PAS2 may be disposed on the first passivation layer PAS1. The first passivation layer PAS1 and the second passivation layer PAS2 may be formed in a single-layered structure or a multi-layered structure including an inorganic insulating material such as silicon oxide (SiOx), silicon nitride (SiNx), aluminum oxide (Al₂O₃), and the like.

The pixel power line VDDL and the common power line VSSL may be disposed on the first passivation layer PAS 1. For example, the pixel power line VDDL and the common power line VSSL may be disposed between the first passivation layer PAS1 and the second passivation layer PAS2. The pixel power line VDDL and the common power line VSSL may be disposed to overlap the touch sensor line TL on the substrate 111. In addition, the pixel power line VDDL and the common power line VSSL may be disposed to overlap the first scan line SCANL1 disposed between the buffer layer BF and the interlayer insulating layer ILD. For example, the pixel power line VDDL and the common power line VSSL may be disposed to overlap a portion of the first scan line SCANL1 extending in the first direction (or Y-axis direction).

A planarization layer PLN for planarizing a step difference due to the thin film transistor and the plurality of signal lines may be disposed on the second passivation layer PAS2. The planarization layer PLN may be formed of an organic material such as acryl resin, epoxy resin, phenolic resin, polyamide resin, polyimide resin, or the like.

An undercut line UCL provided by using the planarization layer PLN and the second passivation layer PAS2 may extend in the first direction (or Y-axis direction) in the transmission area TA. The undercut line UCL may be formed by removing at least a portion of the planarization layer PLN and the second passivation layer PAS2.

The second scan line SCANL2 and the gate bridge pattern GBP crossing the transmission area TA may be disposed below the undercut line UCL. A block pattern BP may be disposed at an intersection of the undercut line UCL, the second scan line SCANL2, and the gate bridge pattern GBP. For example, the block pattern BP may be formed at a portion where the undercut line UCL, the second scan line SCANL2, and the gate bridge pattern GBP intersect.

The transparent display panel 110 according to another embodiment of the present disclosure provides a cutting-enable area by the undercut line UCL in the transmission area TA so that it is possible to implement or realize a cuttable transparent display panel manufactured by being divided into various sizes according to the application and use. Meanwhile, in the transparent display panel 110 according to another embodiment of the present disclosure, according as the gate bridge pattern GBP is electrically connected to the first scan line SCANL1, it may replace the role of the first scan line SCANL1, and it is possible to omit the arrangement of the first scan line SCANL1 crossing the transmission area TA by sharing the area crossing the transmission area TA with the second scan line SCANL2, thereby securing a margin of the transmission area TA and improving the light transmittance of the transparent display panel 110. Also, in the transparent display panel 110 according to another embodiment of the present disclosure, it is possible to block external light incident through the substrate 111 by the gate bridge pattern GBP disposed to overlap the second scan line SCANL2 in the transmission area TA, thereby improving the reflectance characteristics of the transparent display panel 110.

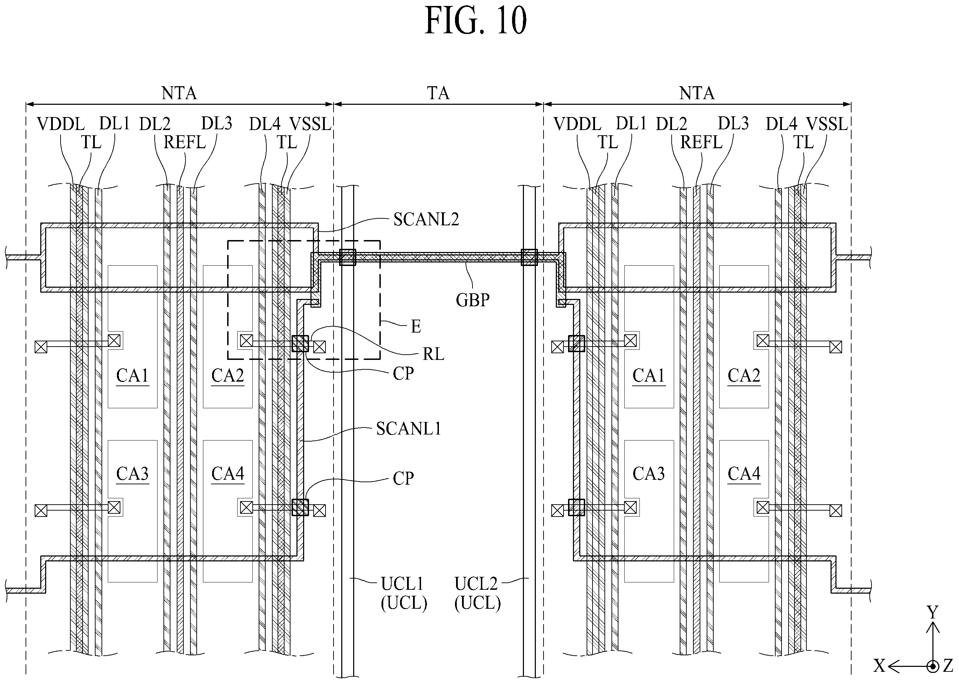

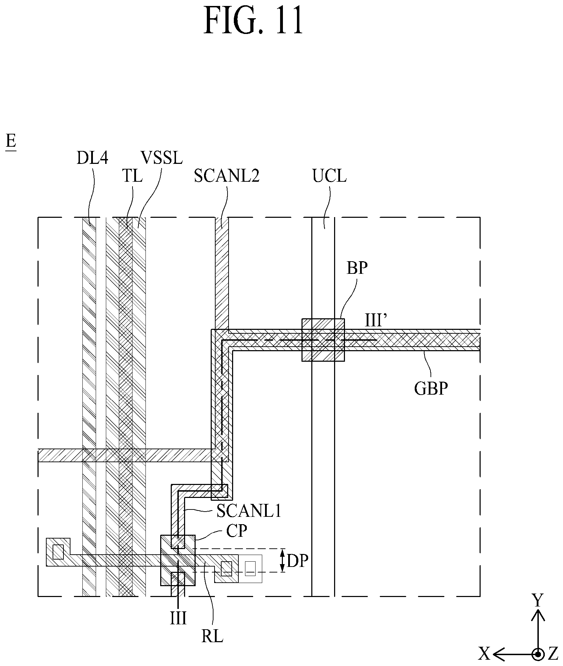

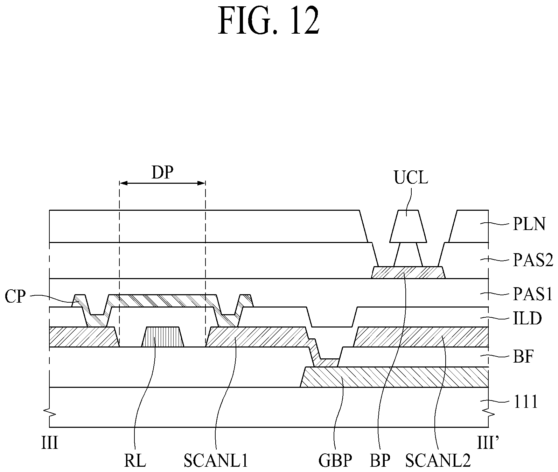

FIG. 10 illustrates a region B shown in FIG. 3 according to another embodiment of the present disclosure. FIG. 11 illustrates a region E shown in FIG. 10 according to another embodiment of the present disclosure. FIG. 12 is a cross-sectional view along III-III' of FIG. 11 according to another embodiment of the present disclosure. FIGs. 10 to 12 are configured by changing a scan line from the transparent display panel 110 described with reference to FIGs. 1 to 6. Accordingly, in the following description, the same reference numerals are assigned to the same elements except for a configuration related to the scan line, and a redundant description thereof will be omitted or briefly described.

Referring to FIGs. 10 to 12, a transparent display panel 110 according to another embodiment of the present disclosure may include at least one scan line SCANL and a gate bridge pattern GBP.

At least one scan line SCANL may include a first scan line SCANL1 and a second scan line SCANL2.

The first scan line SCANL1 may be disposed in a non-transmission area NTA. For example, at least a portion of the first scan line SCANL1 may extend in a second direction (or X-axis direction) in the non-transmission area NTA. The first scan line SCANL 1 may be bent at least once in the non-transmission area NTA and may extend in a first direction (or Y-axis direction). For example, the first scan line SCANL1 may be disposed to intersect with at least one of a touch sensor line TL, a pixel power line VDDL, and a common power line VSSL in the non-transmission area NTA. The first scan line SCANL1 may be disposed on a different layer from the touch sensor line TL, the pixel power line VDDL, and the common power line VSSL.

The first scan line SCANL1 may extend in the second direction (or X-axis direction) in the non-transmission area NTA and may intersect with the touch sensor line TL, the pixel power line VDDL, and the common power line VSSL, and then may be bent in the first direction (or Y-axis direction) and may be extended. For example, the first scan line SCANL 1 may be connected to pixels P corresponding to a lower horizontal line of two adjacent horizontal lines. For example, the first scan line SCANL1 may be connected to the pixels P corresponding to the lower horizontal line of the two adjacent horizontal lines, may extend in the second direction (or X-axis direction) to intersect with the touch sensor line TL, the pixel power line VDDL, and the common power line VSSL, and may be bent in the first direction (or Y-axis direction) and may extend in parallel to at least one of the touch sensor line TL, the pixel power line VDDL without overlapping therewith , and the common power line VSSL. For example, a portion of the first scan line SCANL1 may be disposed adjacent to at least a portion of the touch sensor line TL, the pixel power line VDDL, and the common power line VSSL extending in the first direction (or Y-axis direction) without overlapping therewith.

The transparent display panel 110 according to another embodiment of the present disclosure provides a cutting-enable area by an undercut line UCL in a transmission area TA so that it is possible to implement or realize a cuttable transparent display panel manufactured by being divided into various sizes according to the application and use. Meanwhile, in the transparent display panel 110 according to another embodiment of the present disclosure, the second scan line SCANL2 and the gate bridge pattern GBP share the area across the transmission area TA so that it is possible to secure a margin of the transmission area TA, thereby improving light transmittance of the transparent display panel 110. Also, in the transparent display panel 110 according to another embodiment of the present disclosure, it is possible to block external light incident through the substrate 111 by the gate bridge pattern GBP disposed to overlap the second scan line SCANL2 in the transmission area TA, thereby improving the reflectance characteristics of the transparent display panel 110. In addition, the transparent display panel 110 according to another embodiment of the present disclosure minimizes the area in which the first scan line SCANL 1 overlaps the touch sensor line TL, the pixel power line VDDL, and the common power line VSSL, thereby preventing a generation of parasitic capacitance. Accordingly, it is possible to improve a driving reliability of the transparent display panel 110.

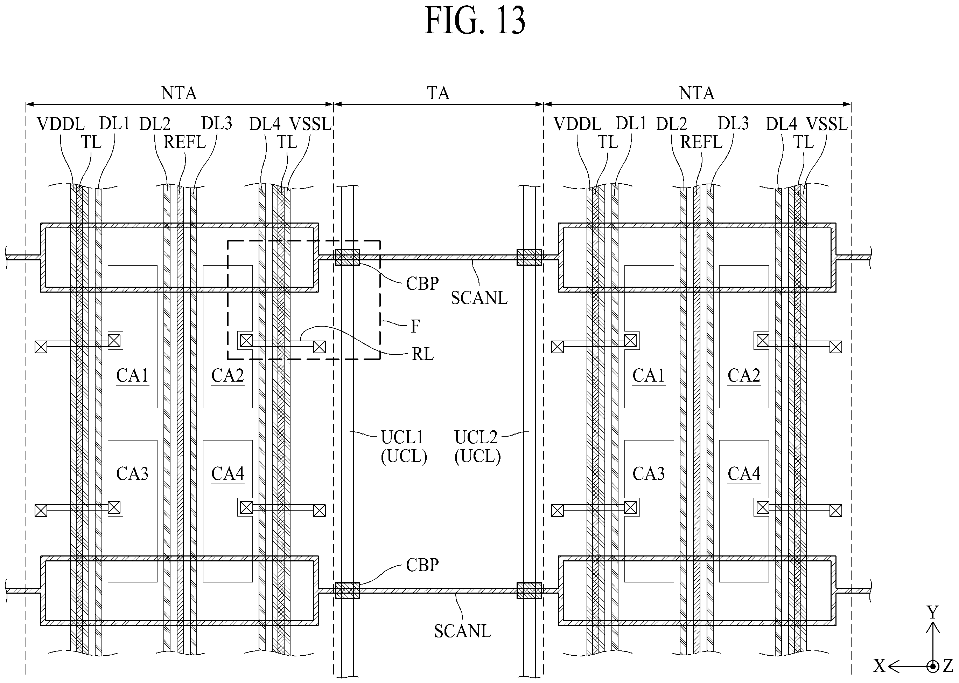

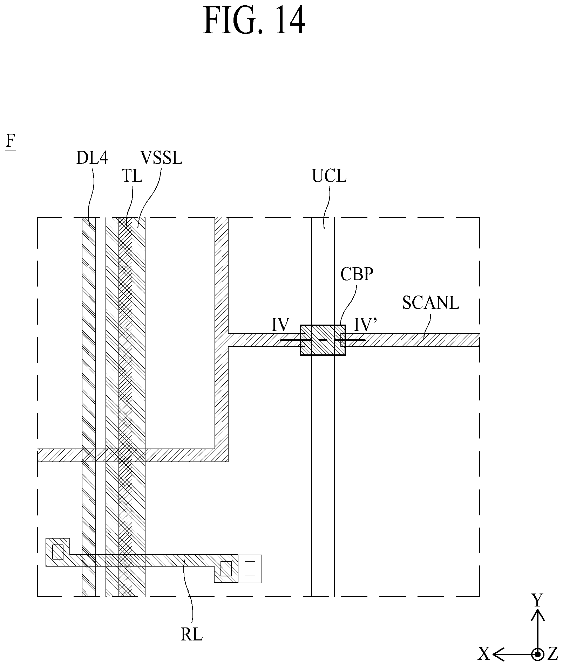

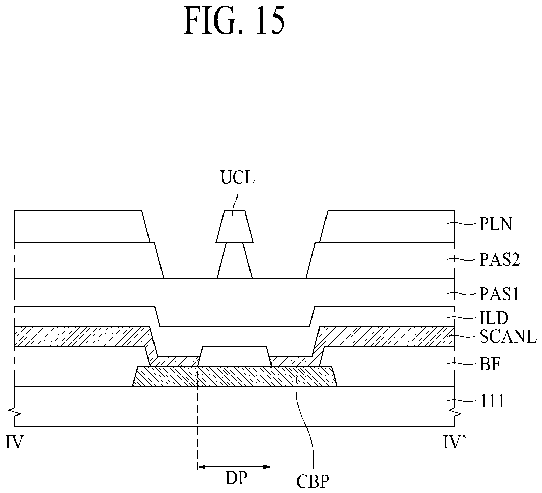

FIG. 13 illustrates a region B shown in FIG. 3 according to another embodiment of the present disclosure. FIG. 14 illustrates a region F shown in FIG. 13 according to another embodiment of the present disclosure. FIG. 15 is a cross-sectional view along IV-IV' of FIG. 14 according to another embodiment of the present disclosure. FIGs. 13 to 15 are configured by changing a scan line from the transparent display panel 110 described with reference to FIGs. 1 to 6. Accordingly, in the following description, the same reference numerals are assigned to the same elements except for a configuration related to the scan line, and a redundant description thereof will be omitted or briefly described.

Referring to FIGs. 13 to 15, a transparent display panel 110 according to another embodiment of the present disclosure may include at least one scan line SCANL and a connection bridge pattern CBP.

At least one scan line SCANL may be disposed in a non-transmission area NTA and a transmission area TA. At least a portion of the at least one scan line SCANL may be arranged to extend in a second direction (or X-axis direction) to cross the transmission area TA.

An undercut line UCL may be formed to extend in a first direction (or Y-axis direction) in the transmission area TA using a planarization layer PLN and a second passivation layer PAS2. The undercut line UCL may be formed by removing at least a portion of the planarization layer PLN and the second passivation layer PAS2.

At least one scan line SCANL crossing the transmission area TA may be disposed under the undercut line UCL. The at least one scan line SCANL may include a divided portion DP spaced apart by a predetermined interval at an area crossing the undercut line UCL. The divided portion DP of the at least one scan line SCANL may be electrically connected by the connection bridge pattern CBP.

Specifically, the connection bridge pattern CBP, which is formed of the same material on the same layer as a light shielding layer, may be disposed on a substrate 111. The connection bridge pattern CBP may be disposed at a portion where one scan line SCANL and the undercut line UCL cross in the transmission area TA. For example, the connection bridge pattern CBP may be formed in a single-layered structure or multi-layered structure of molybdenum (Mo), aluminum (Al), chromium (Cr), gold (Au), titanium (Ti), nickel (Ni), neodymium (Nd), and copper (Cu), or an alloy thereof.

A buffer layer BF may be disposed on the substrate 111 on which the connection bridge pattern CBP and the light shielding layer are disposed. The buffer layer BF protects a thin film transistor vulnerable to moisture permeation from moisture penetrating through the substrate 111. The buffer layer BF may be formed in a single-layered structure or a multi-layered structure including an inorganic insulating material such as silicon oxide (SiOx), silicon nitride (SiNx), aluminum oxide (Al₂O₃), and the like.

At least one scan line SCANL may be disposed on the buffer layer BF. The at least one scan line SCANL may be disposed in the non-transmission area NTA and the transmission area TA. For example, at least a portion of the at least one scan line SCANL may be arranged to extend in the second direction (or X-axis direction) to cross the transmission area TA. The at least one scan line SCANL may include the divided portion DP spaced apart by a predetermined interval at the portion crossing the undercut line UCL in the transmission area TA. The divided portion DP of the at least one scan line SCANL may be spaced apart from each other with the undercut line UCL interposed therebetween. One end and the other end of the at least one scan line SCANL spaced apart from each other with the divided portion DP interposed therebetween may be connected to the connection bridge pattern CBP via a contact hole exposing a portion of the connection bridge pattern CBP by penetrating through the buffer layer BF. One end and the other end of the at least one scan line SCANL separated by the divided portion DP may be electrically connected to each other by the connection bridge pattern CBP.

An interlayer insulating layer ILD, a first passivation layer PAS 1, the second passivation layer PAS2, and the planarization layer PLN may be disposed on the substrate 111 on which at least one scan line SCANL is disposed.

The undercut line UCL may be formed to extend in the first direction (or Y-axis direction) in the transmission area TA using the planarization layer PLN and the second passivation layer PAS2. The undercut line UCL may be formed by removing at least a portion of the planarization layer PLN and the second passivation layer PAS2.

At least one scan line SCANL crossing the undercut line UCL may be spaced apart from the undercut line UCL with the interlayer insulating layer ILD and the first passivation layer PAS1 interposed therebetween. Accordingly, the transparent display panel 110 according to another embodiment of the present disclosure may prevent the at least one scan line SCANL from being damaged by an etchant used for forming the undercut line UCL even though a separate block pattern is not formed.

The transparent display panel 110 according to another embodiment of the present disclosure may provide a cutting-enable area by the undercut line UCL in the transmission area TA so that it is possible to implement or realize a cuttable transparent display panel manufactured by being divided into various sizes according to the application and use. In addition, the transparent display panel 110 according to another embodiment of the present disclosure may exclude the formation of separate block pattern at the portion where the undercut line UCL and at least one scan line SCANL intersect so that it is possible to secure an additional margin of the transmission area TA, thereby improving light transmittance of the transparent display panel 110.

A transparent display apparatus according to one or more embodiments of the present disclosure will be described below.

A transparent display apparatus according to one or more embodiments of the present disclosure may include a substrate including a transmission area and a non-transmission area having an emission area in which a light emitting element is disposed, at least one gate line crossing the non-transmission area and the transmission area on the substrate, and a gate bridge pattern in the transmission area of the substrate, the gate bridge pattern at least partially overlapped with the at least one gate line.

According to one or more embodiments of the present disclosure, the gate bridge pattern may be electrically connected to the at least one gate line.

According to one or more embodiments of the present disclosure, the at least one gate line may include a first gate line and a second gate line, and the gate bridge pattern may be electrically connected to the first gate line and may be electrically separated from the second gate line.

According to one or more embodiments of the present disclosure, the first gate line may be disposed in the non-transmission area, and the second gate line may be disposed in the non-transmission area and the transmission area.

According to one or more embodiments of the present disclosure, the first gate line may be connected to pixels corresponding to a lower horizontal line of two adjacent horizontal lines, and the second gate line may be connected to pixels corresponding to an upper horizontal line of the two adjacent horizontal lines.

According to one or more embodiments of the present disclosure, the gate bridge pattern may extend in parallel with the second gate line and overlaps with the second gate line in the transmission area.

According to one or more embodiments of the present disclosure, the gate bridge pattern may be spaced apart from the second gate line with at least one insulating layer interposed between the gate bridge pattern and the second gate line.

According to one or more embodiments of the present disclosure, the gate bridge pattern may be electrically connected to the first gate line through a contact hole passing through at least one insulating layer.

According to one or more embodiments of the present disclosure, may further include at least one power line extending in a first direction on the substrate, the at least one gate line may include a first gate line extending in parallel with the first direction and a second gate line extending in a second direction crossing the first direction.

According to one or more embodiments of the present disclosure, the at least one power line and the first gate line may be disposed in the non-transmission area, and the second gate line may be disposed in the non-transmission area and the transmission area.

According to one or more embodiments of the present disclosure, the first gate line may overlap with the at least one power line in the non-transmission area.

According to one or more embodiments of the present disclosure, the first gate line may extend in parallel with the at least one power line without overlapping therewith while being adjacent thereto in the non-transmission area.

According to one or more embodiments of the present disclosure, the first gate line may include divided portions that are spaced apart from each other in the non-transmission area, and a connection pattern for an electrical connection of the divided portions.

According to one or more embodiments of the present disclosure, another metal pattern in the non-transmission area may be in the divided portion of the first gate line.

According to one or more embodiments of the present disclosure, the gate bridge pattern may be electrically connected to the first gate line, may be electrically separated from the second gate line, and may extend in parallel with the second gate line.

According to one or more embodiments of the present disclosure, the gate bridge pattern may be on the substrate, and the at least one gate line may be on a first insulating layer covering the gate bridge pattern.

According to one or more embodiments of the present disclosure, the at least one gate line may include divided portions that are spaced apart from each other, and a connection pattern for an electrical connection of the divided portion, and the connection pattern may be on a second insulating layer covering the at least one gate line, and may electrically connect the divided portion through a contact hole passing through the second insulating layer.

According to one or more embodiments of the present disclosure, may further include at least one power line extending in a first direction on the substrate, the at least one power line may be on a third insulating layer covering the at least one gate line and the connection pattern.

According to one or more embodiments of the present disclosure, may further include at least one undercut line in the transmission area on the substrate, the at least one undercut line extending in a first direction.

According to one or more embodiments of the present disclosure, the at least one undercut line may include a first undercut line and a second undercut line, the first undercut line being disposed adjacent to a pixel on one side of the transmission area, and the second undercut line being disposed adjacent to a pixel on the other side of the transmission area.

According to one or more embodiments of the present disclosure, the at least one undercut line may disconnect an organic light emitting layer included in the light emitting element.

According to one or more embodiments of the present disclosure, the at least one undercut line may be configured as a part of at least one protection layer on the at least one gate line.

According to one or more embodiments of the present disclosure, the at least one undercut line may be formed by removing at least a portion of at least one protection layer.

According to one or more embodiments of the present disclosure, may further include a block pattern at an intersection of the at least one gate line and the at least one undercut line.

According to one or more embodiments of the present disclosure, the block pattern may be between the at least one undercut line and the at least one gate line.

A transparent display apparatus according to one or more embodiments of the present disclosure may include a substrate including a transmission area and a non-transmission area having an emission area in which a light emitting element is disposed; at least one undercut line disposed in the transmission area on the substrate and extending in a first direction; at least one gate line crossing the non-transmission area and the transmission area on the substrate, the at least one gate line including a divided portion spaced apart by a predetermined interval at a portion crossing the at least one undercut line in the transmission area; and a connection bridge pattern disposed at a portion where the at least one gate line and the at least one undercut line, the divided portion of the at least one gate line being electrically connected by the connection bridge pattern.

According to one or more embodiments of the present disclosure, the connection bridge pattern may be disposed on the substrate, and the at least one gate line may be disposed on an insulating layer covering the connection bridge pattern.

According to one or more embodiments of the present disclosure, one end and the other end of the at least one gate line separated by the divided portion may be electrically connected to the connection bridge pattern through a contact hole penetrating through the insulating layer.

According to one or more embodiments of the present disclosure, the at least one undercut line may be configured to disconnect an organic light emitting layer constituting the light emitting element.

According to one or more embodiments of the present disclosure, the at least one undercut line may be configured as a part of at least one protection layer on the at least one gate line.

According to one or more embodiments of the present disclosure, the at least one undercut line may be formed by removing at least a portion of the at least one protection layer.

It will be apparent to those skilled in the art that various modifications and variations may be made in the apparatus of the present disclosure without departing from the scope of the disclosure. Thus, it is intended that the present disclosure cover the modifications and variations of this disclosure provided that within the scope of the claims and their equivalents.

The present disclosure also comprises the following clauses:
1. A transparent display apparatus comprising:
   a substrate including a transmission area and a non-transmission area having an emission area in which a light emitting element is disposed;
   at least one gate line crossing the non-transmission area and the transmission area on the substrate; and
   a gate bridge pattern in the transmission area of the substrate, the gate bridge pattern at least partially overlapped with the at least one gate line.
2. The transparent display apparatus according to clause 1, wherein the gate bridge pattern is electrically connected to the at least one gate line.
3. The transparent display apparatus according to clause 1 or clause 2,
   wherein the at least one gate line includes a first gate line and a second gate line, and
   wherein the gate bridge pattern is electrically connected to the first gate line and is electrically separated from the second gate line, and optionally wherein the gate bridge pattern is electrically connected to the first gate line through a contact hole passing through at least one insulating layer.
4. The transparent display apparatus according to clause 3,
   wherein the first gate line is disposed in the non-transmission area, and the second gate line is disposed in the non-transmission area and the transmission area.
5. The transparent display apparatus according to clause 3 or clause 4,
   wherein the first gate line is connected to pixels corresponding to a lower horizontal line of two adjacent horizontal lines, and the second gate line is connected to pixels corresponding to an upper horizontal line of the two adjacent horizontal lines.
6. The transparent display apparatus according to any one of clauses 3 to 5,
   wherein the gate bridge pattern extends in parallel with the second gate line and overlaps with the second gate line in the transmission area; and optionally:
   wherein the gate bridge pattern is spaced apart from the second gate line with at least one insulating layer interposed between the gate bridge pattern and the second gate line.
7. The transparent display apparatus according to clause 1 or clause 2, further comprising at least one power line extending in a first direction on the substrate,
   wherein the at least one gate line includes a first gate line extending in parallel with the first direction and a second gate line extending in a second direction crossing the first direction.
8. The transparent display apparatus according to clause 7,
   wherein the at least one power line and the first gate line are disposed in the non-transmission area, and the second gate line is disposed in the non-transmission area and the transmission area.
9. The transparent display apparatus according to clause 7 or clause 8,
   wherein the first gate line overlaps with the at least one power line in the non-transmission area; or
   wherein the first gate line extends in parallel with the at least one power line without overlapping therewith while being adjacent thereto in the non-transmission area.
10. The transparent display apparatus according to any one of clauses 7 to 9,
   wherein the gate bridge pattern is electrically connected to the first gate line, is electrically separated from the second gate line, and extends in parallel with the second gate line.
11. The transparent display apparatus according to any one of clauses 3 to 10,
   wherein the first gate line includes:
   divided portions that are spaced apart from each other in the non-transmission area; and
   a connection pattern for an electrical connection of the divided portions;
   and optionally:
      wherein another metal pattern in the non-transmission area is in the divided portion of the first gate line.
12. The transparent display apparatus according to any one of clauses 1 to 6,
   wherein the gate bridge pattern is on the substrate, and
   the at least one gate line is on a first insulating layer covering the gate bridge pattern;
   and optionally:
      wherein the at least one gate line includes divided portions that are spaced apart from each other, and a connection pattern for an electrical connection of the divided portions, and
      wherein the connection pattern is on a second insulating layer covering the at least one gate line, and electrically connects the divided portions through a contact hole passing through the second insulating layer;
      and optionally:

      further comprising at least one power line extending in a first direction on the substrate,
      wherein the at least one power line is on a third insulating layer covering the at least one gate line and the connection pattern.
13. The transparent display apparatus according to any preceding clause, further comprising at least one undercut line in the transmission area on the substrate, the at least one undercut line extending in a first direction.
14. The transparent display apparatus according to clause 13, wherein the at least one undercut line includes a first undercut line and a second undercut line, the first undercut line being disposed adjacent to a pixel on one side of the transmission area, and the second undercut line being disposed adjacent to a pixel on the other side of the transmission area; or
   wherein the at least one undercut line disconnects an organic light emitting layer included in the light emitting element; or
   wherein the at least one undercut line is configured as a part of at least one protection layer on the at least one gate line, and optionally wherein the at least one undercut line is formed by removing at least a portion of the at least one protection layer.
15. The transparent display apparatus according to clause 13 or clause 14, further comprising a block pattern at an intersection of the at least one gate line and the at least one undercut line;
   and optionally:
   wherein the block pattern is between the at least one undercut line and the at least one gate line.
16. A transparent display apparatus comprising:
   a substrate including a transmission area and a non-transmission area having an emission area in which a light emitting element is disposed;
   at least one undercut line disposed in the transmission area on the substrate and extending in a first direction;
   at least one gate line crossing the non-transmission area and the transmission area on the substrate, the at least one gate line including a divided portion spaced apart by a predetermined interval at a portion crossing the at least one undercut line in the transmission area; and
   a connection bridge pattern disposed at a portion where the at least one gate line and the at least one undercut line, the divided portion of the at least one gate line being electrically connected by the connection bridge pattern.
17. The transparent display apparatus according to clause 16,
   wherein the connection bridge pattern is disposed on the substrate, and
   the at least one gate line is disposed on an insulating layer covering the connection bridge pattern.
18. The transparent display apparatus according to any one of clauses 16 to 17 ,
   wherein one end and the other end of the at least one gate line separated by the divided portion are electrically connected to the connection bridge pattern through a contact hole penetrating through the insulating layer.
19. The transparent display apparatus according to any one of clauses 16 to 18,
   wherein the at least one undercut line is configured to disconnect an organic light emitting layer constituting the light emitting element.
20. The transparent display apparatus according to any one of clauses 16 to 19,
   wherein the at least one undercut line is configured as a part of at least one protection layer on the at least one gate line.
21. The transparent display apparatus according to any one of clauses 16 to 20,
   wherein the at least one undercut line is formed by removing at least a portion of the at least one protection layer.

## Claims

1. A transparent display apparatus comprising:
a substrate including a transmission area and a non-transmission area having an emission area in which a light emitting element is disposed;
at least one gate line crossing the non-transmission area and the transmission area on the substrate; and
a gate bridge pattern in the transmission area of the substrate, the gate bridge pattern at least partially overlapped with the at least one gate line.

2. The transparent display apparatus according to claim 1, wherein the gate bridge pattern is electrically connected to the at least one gate line.

3. The transparent display apparatus according to claim 1 or claim 2,
wherein the at least one gate line includes a first gate line and a second gate line, and
wherein the gate bridge pattern is electrically connected to the first gate line and is electrically separated from the second gate line, and optionally wherein the gate bridge pattern is electrically connected to the first gate line through a contact hole passing through at least one insulating layer.

4. The transparent display apparatus according to claim 3,
wherein the first gate line is disposed in the non-transmission area, and the second gate line is disposed in the non-transmission area and the transmission area.

5. The transparent display apparatus according to claim 3 or claim 4,
wherein the first gate line is connected to pixels corresponding to a lower horizontal line of two adjacent horizontal lines, and the second gate line is connected to pixels corresponding to an upper horizontal line of the two adjacent horizontal lines.

6. The transparent display apparatus according to any one of claims 3 to 5, wherein the gate bridge pattern extends in parallel with the second gate line and overlaps with the second gate line in the transmission area; and optionally:
wherein the gate bridge pattern is spaced apart from the second gate line with at least one insulating layer interposed between the gate bridge pattern and the second gate line.

7. The transparent display apparatus according to claim 1 or claim 2, further comprising at least one power line extending in a first direction on the substrate,
wherein the at least one gate line includes a first gate line extending in parallel with the first direction and a second gate line extending in a second direction crossing the first direction.

8. The transparent display apparatus according to claim 7,
wherein the at least one power line and the first gate line are disposed in the non-transmission area, and the second gate line is disposed in the non-transmission area and the transmission area.

9. The transparent display apparatus according to claim 7 or claim 8,
wherein the first gate line overlaps with the at least one power line in the non-transmission area; or
wherein the first gate line extends in parallel with the at least one power line without overlapping therewith while being adjacent thereto in the non-transmission area.

10. The transparent display apparatus according to any one of claims 7 to claim 9, wherein the gate bridge pattern is electrically connected to the first gate line, is electrically separated from the second gate line, and extends in parallel with the second gate line.

11. The transparent display apparatus according to any one of claims 3 to 10, wherein the first gate line includes:
divided portions that are spaced apart from each other in the non-transmission area; and
a connection pattern for an electrical connection of the divided portions;
and optionally:
wherein another metal pattern in the non-transmission area is in the divided portion of the first gate line.

12. The transparent display apparatus according to any one of claims 1 to 6, wherein the gate bridge pattern is on the substrate, and
the at least one gate line is on a first insulating layer covering the gate bridge pattern;
and optionally:
wherein the at least one gate line includes divided portions that are spaced apart from each other, and a connection pattern for an electrical connection of the divided portions, and
wherein the connection pattern is on a second insulating layer covering the at least one gate line, and electrically connects the divided portions through a contact hole passing through the second insulating layer;
and optionally:
further comprising at least one power line extending in a first direction on the substrate,
wherein the at least one power line is on a third insulating layer covering the at least one gate line and the connection pattern.

13. The transparent display apparatus according to any preceding claim, further comprising at least one undercut line in the transmission area on the substrate, the at least one undercut line extending in a first direction.

14. The transparent display apparatus according to claim 13, wherein the at least one undercut line includes a first undercut line and a second undercut line, the first undercut line being disposed adjacent to a pixel on one side of the transmission area, and the second undercut line being disposed adjacent to a pixel on the other side of the transmission area; or
wherein the at least one undercut line disconnects an organic light emitting layer included in the light emitting element; or
wherein the at least one undercut line is configured as a part of at least one protection layer on the at least one gate line, and optionally wherein the at least one undercut line is formed by removing at least a portion of the at least one protection layer.

15. The transparent display apparatus according to claim 13 or claim 14, further comprising a block pattern at an intersection of the at least one gate line and the at least one undercut line;
and optionally:
wherein the block pattern is between the at least one undercut line and the at least one gate line.
